# EUROPEAN PATENT APPLICATION

(11) **EP 4 596 654 A1**
(43) Date of publication of application: **06.08.2025**
(21) Application number: 23941152.3
(22) Date of filing: 30.06.2023
(51) Int. Cl.: C09K 11/61, C09K 11/66, C09K 11/67, F21K 9/64, G02F 1/13357, H01L 33/50, F21Y 115/10

(54) **RED PHOSPHOR, PREPARATION METHOD THEREFOR, AND USE THEREOF**

(30) Priority: 16.06.2023 CN 202310723295
(71) Applicant: Jiangsu Bree Optronics Co., Ltd, Nanjing, Jiangsu 211103 (CN); Jiangsu Cherrity Optronics Co., Ltd, Nanjing, Jiangsu 211103 (CN)
(72) Inventor: HE, Jinhua, Nanjing, Jiangsu 211103 (CN); ZHONG, Bo, Nanjing, Jiangsu 211103 (CN); YAO, Leqi, Nanjing, Jiangsu 211103 (CN); WANG, Jing, Nanjing, Jiangsu 211103 (CN); LIANG, Chao, Nanjing, Jiangsu 211103 (CN)
(74) Representative: Winter, Brandl - Partnerschaft mbB
(86) International application number: PCT/CN2023/105017
(87) International publication number: WO 2024/254922

(57) **Abstract**

The present application discloses a red phosphor, and a preparation method and an application thereof and relates to the field of luminescent material technology. The chemical composition of the red phosphor is A₂M₍₁₋ₓ₎F₆:xMn⁴⁺. The A is selected from at least one of alkali metal elements, and the M is selected from at least one of IVA group elements or a Ti element and a value range of the x is 0<x ≤0.05. The red phosphor is granular; and a concentration of tetravalent manganese ions in a radial direction from a center of a particle of the red phosphor to a surface of the particle of the red phosphor decreases gradually. In the present application, the concentration of the activator Mn⁴⁺ in a radial direction from the center of the particle of the red phosphor to its surface is set to a descending gradient distribution to buffer the phosphor powder from the erosion of water vapor, thereby improving its anti-aging performance and prolonging the service life.

## Description

### FIELD

The present application relates to the field of luminescent material technology, and in particular to a red phosphor, and a preparation method and an application thereof.

### BACKGROUND

In 1973, Paulusz, from Osram in Germany, first reported K₂SiF₆:Mn⁴⁺ fluoride fluorescent material. Since 2006, the research of the fluoride fluorescent material has gradually become the focus of industrialization. However, the water resistance of the K₂SiF₆:Mn⁴⁺ phosphor activated by tetravalent manganese is poor. That is, the Mn⁴⁺ existing on the surface of the phosphor particles is exposed to moisture in the air, which would be oxidized to dark manganese oxides. This leads to a decrease in the brightness of the K₂SiF₆:Mn⁴⁺ phosphor activated by tetravalent manganese during service, resulting in a short service cycle.

The related technologies disclose the surface reduction of the synthesized K₂SiF₆:Mn⁴⁺ fluoride phosphor. That is, a non-quaternary Mn shell structure is constructed. However, this would destroy the crystal structures of particles surface undoubtedly, resulting in the destruction of the crystal field structures of the manganese-poor layer on the surface, thereby reducing the luminous efficiency. At the same time, the destruction of the lattices on the surface of the phosphor particles would also bring potential deterioration channels to the erosion of water vapor. In the harsh aging environment, once the water molecules penetrate the shell surface layer without activator Mn⁴⁺ doping and establish water molecular channels, the anti-deterioration ability of the K₂SiF₆:Mn⁴⁺ phosphor would decrease sharply. However, further increasing the shell thickness of the shell layer without Mn⁴⁺ activator doping would affect the blue light absorbed by the K₂SiF₆:Mn⁴⁺ phosphor and reduce the quantum efficiency.

### SUMMARY OF INVENTION

The present application provides a red phosphor, and a preparation method and an application thereof. In the present application, a concentration of activator Mn⁴⁺ in a radial direction from a center of a particle of the red phosphor to a surface of the particle of the red phosphor is reduced in form of a gradient distribution, so as to buffer erosion of water vapor on phosphor powder. Furthermore, a concentration of tetravalent manganese ions on the surface of the particle of the red phosphor is reduced to zero. Specifically, by in-situ synthesis of a manganese-free shell layer, on the one hand, the manganese-free shell layer avoids destruction of surface lattices of a crystal by the post-treatment of a reducing agent, and protects a structure of the crystal itself; on the other hand, it could further improve anti-aging ability of the phosphor powder (or anti-deterioration ability).

In a first aspect, the present application provides a red phosphor, the red phosphor is selected from any one of substances shown in a formula I;

A₂M₍₁₋ₓ₎F₆:xMn⁴⁺ the formula I;

in the formula I, the A is selected from at least one of alkali metal elements, the M is selected from at least one of IVA group elements or a Ti element, a value range of the x is 0<x≤0.05, a concentration of tetravalent manganese ions of a particle of the red phosphor decreases gradually in a radial direction from a center of the particle of the red phosphor to a surface of the particle of the red phosphor. In some embodiments, in the formula I, the A is selected from at least one of a Na element and a K element, and the M is selected from at least one of an Si element, a Ge element and the Ti element. In some embodiments, in the formula I, the A is selected from at least one of the Na element and the K element, or the M is selected from at least one of the Si element, the Ge element and the Ti element. Preferably, in some embodiments, the A is the K element or the M is the Si element. More preferably, in some embodiments, the A is the K element and the M is the Si element. In the present application, the concentration of activator Mn⁴⁺ in the radial direction from the center of the particle of the red phosphor to the surface of the particle of the red phosphor is reduced in form of a gradient distribution, so as to buffer erosion of water vapor on the phosphor powder, thus extending the service cycle of the phosphor powder.

In some embodiments, the concentration of the tetravalent manganese ions in the radial direction from the center of the particle of the red phosphor to the surface of the particle of the red phosphor decreases linearly and uniformly. In this way, the anti-aging performance of the phosphor powder is better, which is more conducive to extending the service cycle.

In some embodiments, the concentration of the tetravalent manganese ions on the surface of the particle of the red phosphor is zero. At this time, the surface of the particle of the red phosphor forms a manganese-free shell layer in situ, and the manganese-free shell layer could further improve the anti-aging performance of the phosphor powder.

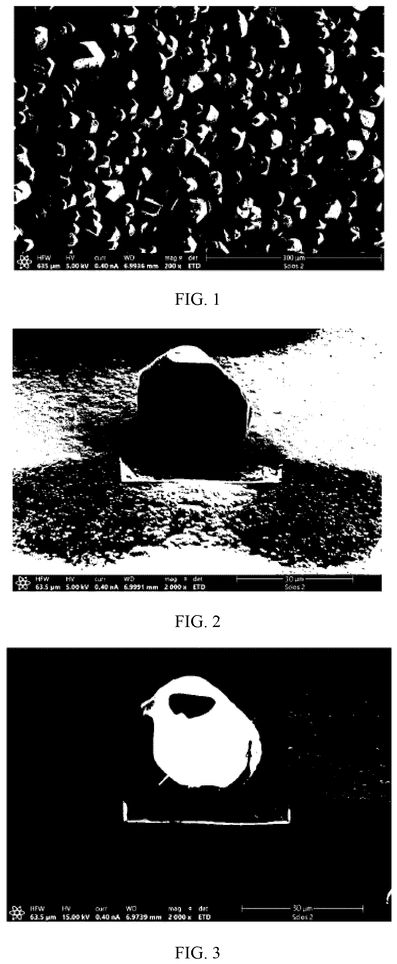

As shown in FIG. 1, a shape of the particle of the red phosphor is spherical-like. A position of a center of the particle of the red phosphor with a spherical-like structure could be assisted in being determined by means of a high energy ion beam. Specifically, the high energy ion beam cuts the particle of the red phosphor along a height center of the particle of the red phosphor, and a fresh surface of the cut is shown in FIG. 2. Then, two line segments LL' and L₁L₁' are taken to connect the surface of the particle (the longest two line segments that are available on the fresh surface). An intersection point of the LL' and the L₁L₁' is denoted as O, and an area surrounded by O as a center of the circle and r as the radius could be regarded as a center A of the particle of the red phosphor described in the present application; wherein 0≤r≤0.1R, the R is a radius of the particle of the red phosphor, and a median particle size of the particle of the red phosphor is 20 µm to 40 µm. Preferably, the median particle size of the particle of the red phosphor is 28 µm to 32 µm. More preferable, the median particle size of the particle of the red phosphor is 30 µm. The A determined by the above method is a center (or a body center) of the particle of the red phosphor, and B is a point randomly selected at the outer edge of the fresh surface of the particle of the red phosphor. The present application does not specify the specific position of the B, as long as it is on the outer surface of the particle of the red phosphor. Taking a point A as a starting point, a direction of extension from the point A towards a point B is a radial direction from the center of the particle of the red phosphor to the surface of the particle of the red phosphor. That is, a concentration of Mn⁴⁺ in the direction of extension from the point A to the point B gradually decreases. Preferably, the concentration of Mn⁴⁺ decreases linearly and uniformly from the point A to the point B. Preferably, the concentration of Mn⁴⁺ at the point B is zero.

In some embodiments, a percentage of manganese atoms in the center of the particle of the red phosphor is denoted as x₁%, and the percentage of manganese atoms on the surface of the particle of the red phosphor is denoted as x₂%, which satisfies: 0≤x₂/x₁<1. By controlling a ratio of a manganese atoms content on the surface of the particle of the red phosphor to a manganese atoms content at a center position in a suitable range, it is beneficial to buffer the erosion of water vapor on the phosphor powder, thereby prolonging the anti-aging ability of the phosphor powder. For example, a ratio x₂/x₁ of the percentage of the manganese atoms on the surface of the particle of the red phosphor to the percentage of the manganese atoms in the center of the particle of the red phosphor is 0, 0.05, 0.1, 0.15, 0.18, 0.19, 0.2, 0.25, 0.3, 0.33, 0.35, 0.5, 0.6, 0.7, 0.8, 0.9 or a range of any two of the above values. Preferably, in some embodiments, the x₂/x₁ satisfies: 0≤ x₂/x₁<0.33. More preferably, in some embodiments, the x₂/x₁ satisfies: 0≤x₂/x₁<0.2.

In some embodiments, the percentage of the manganese atoms in the center of the particle of the red phosphor is x₁%, which satisfies: 0.1≤x₁<5. The highest percentage of the manganese atom at the center position A of the particle of the red phosphor could be 5%. A higher content of the manganese atoms (e.g., higher than 5%) at the center of a phosphor particle is not conducive to the improvement of luminescence intensity, and the luminescence performance is also poor. A lower percentage of manganese atoms in the center of the phosphor particle could not be less than 0.1%. If a percentage of the manganese atoms in the center of the phosphor particle is too low (for example, less than 0.1%), a content of doped activator Mn⁴⁺ in the powder would be too low, which is not conducive to improving the luminescence performance. For example, the percentage content of the manganese atoms x₁% at the center of the particle of the red phosphor is 0.1%, 0.3%, 0.5%, 0.6%, 0.7%, 0.8%, 0.9%, 1%, 1.5%, 2%, 3%, 4%, 5% or a range of any two of the above values. Preferably, in some embodiments, the x₁ satisfies: 0.5≤x₁≤1.

In some embodiments, the percentage of the manganese atom on the surface of the particle of the red phosphor is x₂%, which satisfies: 0≤x₂<0.1. At this time, the anti-aging performance of the red phosphor is better. For example, the percentage x₂% of the manganese atom on the surface of the particle of the red phosphor is 0%, 0.01%, 0.03%, 0.05%, 0.06%, 0.08%, 0.09% or a range of any two of the above values.

In a second aspect, the present application provides a preparation method of the red phosphor mentioned above, comprising following steps:
(1) obtaining a mixed solution of a source of the A and an aqueous solution of hydrofluoric acid, denoted as an A solution;
   wherein the source of the A comprises at least one of fluoride of the A, a hydrogen fluoride salt of the A, sulfate of the A, a nitrate of the A, hydrogen sulfate salt of the A, a carbonate of the A or bicarbonate of the A; and
   a mass percentage of the hydrofluoric acid in the aqueous solution of the hydrofluoric acid is 40%.
(2) obtaining a mixed solution of a source of Mn and a source of the M (a H₂MF₆ hydrofluoric acid solution), denoted as BX solutions;
   wherein, a mass percentage of the H₂MF₆ in the H₂MF₆ hydrofluoric acid solution is 20%-40%; the BX solutions comprises BX₁ solution, BX₂ solution,..., BXn solution, which satisfies: n≥5, and a content of the source of the Mn from the BX₁ solution to the BXₙ solution gradually decreases; optionally, the content of the source of Mn in the BXn solution is 0;
   that is, the content of the source of Mn in the BXₙ solution may or may not be 0. When the content of the source of Mn in the BXₙ solution is 0, the surface of the particle of the red phosphor is in-situ synthesized into the manganese-free shell layer. The manganese-free shell layer could effectively avoid Mn⁴⁺ existing on the surface of a phosphor particle from being exposed to the water in the air, thus further improving the anti-aging ability of the phosphor powder.
(3) injecting the BX solutions of (2) into the A solution of (1) in a order from the BX₁ solution to the BXₙ solution for reactions, and obtaining the red phosphor.

It should be noted that there is no order between step (1) and step (2). The A solution could be prepared first and then the BX solution, or the BX solution could be prepared first and then the A solution. Here, based on the actual situation to determine the corresponding specific choice, the present application does not limit this.

In some embodiments, in step (2), the content of the source of Mn from the BX₁ solution to the BXₙ solution decreases linearly and uniformly; optionally, the content of the source of Mn from the BX₁ solution to the BXₙ solution decreases uniformly in a form of an arithmetic sequence.

In some embodiments, in step (3), an injection rate of the BX solution is 10-50 mL/s, and an injection interval is 5-15 min; and conditions of the reaction are: a reaction temperature is 40-50 °C, and reaction time is 2-4 h.

In some embodiments, in step (1), a mass ratio of the source of the A to the hydrofluoric acid is (20-25):(95-105); and in step (2), a molar percentage of the source of Mn to the source of the M is denoted as M₁ in the BX₁ solution, and the molar percentage of the source of Mn to the source of the M is denoted as M₂ in the BXn solution, which satisfies: 0≤M₂/M₁<1.

In a third aspect, the present application provides the red phosphor mentioned above or the red phosphor prepared by the preparation method mentioned above applying to a field of an LCD backlight source or a field of LED lighting.

In a fourth aspect, the present application provides an LCD backlight source, the LCD backlight source comprises an excitation chip and a phosphor coated on the excitation chip, and the phosphor is the red phosphor mentioned above or the red phosphor prepared by the preparation method mentioned above.

In a fifth aspect, the present application provides a lighting device, the lighting device comprises a light emitting device, the light emitting device comprises an excitation chip and a phosphor coated on the excitation chip, and the phosphor is the red phosphor mentioned above or the red phosphor prepared by the preparation method mentioned above.

The beneficial effects of the technical solutions provided by some embodiments of the present application include at least: in the present application, the concentration of the activator Mn⁴⁺ in the radial direction from the center of the particle of the red phosphor to the surface of the particle of the red phosphor is set to a descending gradient distribution to buffer the phosphor powder from the erosion of the water vapor. Compared with the phosphor powder with no gradient setting of a concentration of the activator Mn⁴⁺ in the prior art, the present application has better anti-aging performance. In particular, setting the concentration of the activator Mn⁴⁺ to a linear and uniform gradient distribution is more conducive to improving its anti-aging ability than a nonlinear and non-uniform gradient distribution, and the service period of the phosphor prepared by the former is longer. At the same time, the present application further reduces the concentration of the tetravalent manganese ions on the surface of the particle of the red phosphor to zero, so as to synthesize a manganese-free shell layer in situ on the surface of the phosphor powder. On the one hand, it is beneficial to protect the lattice structure of the crystal itself; on the other hand, it could further improve the anti-aging ability of the phosphor powder.

### DESCRIPTION OF DRAWINGS

In order to more clearly explain the technical scheme in the embodiments of the present application, the following would be a brief introduction to accompanying drawings used in the embodiments. Obviously, the accompanying drawings in the following description are only some of the embodiment examples of the present application. For those skilled in the art, other accompanying drawings could be obtained according to these accompanying drawings without creative effort.
FIG. 1 is a scanning electron microscope diagram of K₂SiF₆:Mn⁴⁺ phosphors prepared by Embodiment 1 in the present application.
FIG. 2 is a fresh surface diagram of the K₂SiF₆:Mn⁴⁺ phosphor prepared in the Embodiment 1 after double-beam ion cutting in the present application.
FIG.3 is a line scan path diagram of EDX line scanning along a center A to a surface B of the K₂SiF₆:Mn⁴⁺ phosphor prepared in the Embodiment 1.
FIG. 4 is an element content diagram of the EDX line scanning in the FIG. 3.
FIG. 5 is a sampling points schematic diagram of energy spectrum analysis of the K₂SiF₆:Mn⁴⁺ phosphors prepared in the Embodiment 1 in the present application.
FIG. 6 is a schematic diagram of distribution curves of relative contents of Mn⁴⁺ at sampling points of Embodiments 1-5 according to the method of the sampling points in the FIG. 5.

### DETAILED DESCRIPTION OF PREFERRED EMBODIMENTS

In order to make the purpose, technical scheme and advantages of the present application clearer, the following combined with the attached figures and implementation examples, the present application is further described in detail. It should be understood that the specific example described here is intended only to explain the present application and not to limit it.

The following are further explanations of the present application through embodiments. Other fluorescent materials used in the present application could be purchased commercially.

### Preparation of KSF phosphors (preparation of K₂SiF₆:Mn⁴⁺)

### Embodiment 1

(1) preparing BX solutions: weighing and dissolving K₂MnF₆ 2.7g, 2.52g, 2.34g, 2.16g, 1.98g, 1.80g, 1.62g, 1.44g, 1.26g, 1.08g, 0.9g, 0.72g, 0.54g, 0.36g, 0.18g and 0g in commercially available 50g 30%-32% HSF (i.e. 30%-32% aqueous solution of fluorosilicic acid) separately to obtain 16 groups of BX solutions. That is, corresponding to a BX₁ solution (comprising K₂MnF₆ 2.7g), a BX₂ solution,..., and a BX₁₆ solution (excluding K₂MnF₆);
(2) preparing an A solution: weighing and dissolving 21g potassium hydrogen difluoride in 250 ml 40% HF aqueous solution (i.e. 40% aqueous solution of hydrofluoric acid) to obtain the A solution;
(3) injecting the BX solutions prepared into the A solution according to the order from the BX₁ solution to the BX₁₆ solution at an interval of 6 min and at an injection rate of 10 mL/s; and stirring for 2 h and layering statically in a case that a temperature is 40 °C; and
(4) post-processing: pouring out a supernatant, adding 5% HF aqueous solution (5% aqueous solution of hydrofluoric acid), stirring and washing twice, then washing twice with anhydrous ethanol, and drying at 60 °C under a condition of blast drying, and obtaining the KSF phosphors.

A median particle size of the KSF phosphor prepared in the Embodiment 1 is 30 µm.

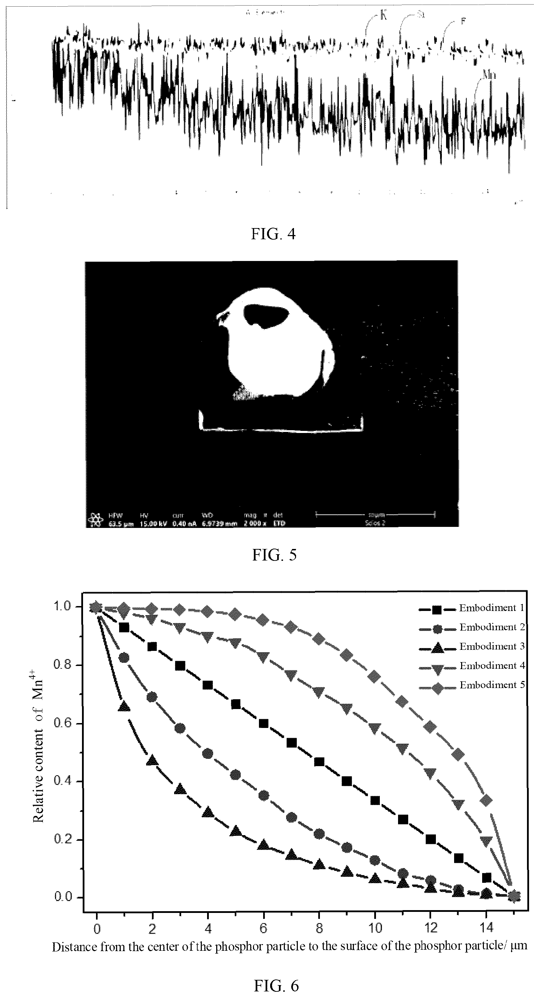

FIG. 1 is a scanning electron microscope diagram of K₂SiF₆:Mn⁴⁺ phosphors prepared by Embodiment 1 in the present application. It could be seen from the FIG. 1 that a shape of the K₂SiF₆:Mn⁴⁺ phosphor prepared by the Embodiment 1 is spherical-like. FIG. 2 is a fresh surface diagram of the K₂SiF₆:Mn⁴⁺ phosphor prepared in the Embodiment 1 after double-beam ion cutting in the present application. FIG. 3 is a line scan path diagram of EDX line scanning along a center A to a surface B of the K₂SiF₆:Mn⁴⁺ phosphor prepared in the Embodiment 1. FIG. 4 is an element content diagram of the EDX line scanning in the FIG. 3. The ordinate CPS of the FIG. 4 represents the count, has no special physical meaning, and only represents the intensity of the detected element signal. FIG. 5 is a sampling points schematic diagram of energy spectrum analysis of the K₂SiF₆:Mn⁴⁺ phosphors prepared in the Embodiment 1 in the present application. FIG. 6 is a schematic diagram of distribution curves of relative contents of Mn⁴⁺ at sampling points of Embodiments 1-5 according to the method of the sampling points in the FIG. 5. It could be seen from FIG. 6 that a concentration of the tetravalent manganese ion in a radial direction from the center of the K₂SiF₆:Mn⁴⁺ particle of the red phosphor prepared in the Embodiment 1 to the surface of the K₂SiF₆:Mn⁴⁺ particle of the red phosphor decreases to zero linearly and uniformly.

### Embodiment 2

(1) preparing BX solutions: weighing and dissolving K₂MnF₆ 2.7g, 2.23g, 1.87g, 1.57g, 1.34g, 1.14g, 0.95g, 0.74g, 0.59g, 0.46g, 0.34g, 0.22g, 0.15g, 0.07g, 0.03g and 0g in commercially available 50g 30%-32% HSF separately to obtain 16 groups of BX solutions. That is, corresponding to a BX₁ solution (comprising K₂MnF₆ 2.7g), a BX₂ solution,..., and a BX₁₆ solution (excluding K₂MnF₆);
(2) preparing an A solution: weighing and dissolving 21g potassium hydrogen difluoride in 250 ml 40% HF aqueous solution to obtain the A solution;
(3) injecting the BX solutions prepared into the A solution according to the order from the BX₁ solution to the BX₁₆ solution at an interval of 10 min and at an injection rate of 15 mL/s; and stirring for 4 h and layering statically in a case that a temperature is 50 °C; and
(4) post-processing: pouring out a supernatant, adding 5% HF aqueous solution, stirring and washing twice, then washing twice with anhydrous ethanol, and drying at 60 °C under a condition of blast drying, and obtaining the KSF phosphors.

A median particle size of the KSF phosphor prepared in the Embodiment 1 is 30 µm.

It could be seen from the FIG. 6 that the concentration of the tetravalent manganese ions in the radial direction from the center of the particle of the red phosphor prepared by the Embodiment 2 to the surface of the particle of the red phosphor decreases to zero non-linearly.

### Embodiment 3

(1) preparing BX solutions: weighing and dissolving K₂MnF₆ 2.7g, 1.77 g, 1.27g, 1.00g, 0.79g, 0.61g, 0.48g, 0.39g, 0.30g, 0.23g, 0.17g, 0.12g, 0.08g, 0.04g, 0.02g and 0g in commercially available 50g 30%-32% HSF separately to obtain 16 groups of BX solutions. That is, corresponding to a BX₁ solution (comprising K₂MnF₆ 2.7g), a BX₂ solution,..., and a BX₁₆ solution (excluding K₂MnF₆ );
(2) preparing an A solution: weighing and dissolving 21g potassium hydrogen difluoride in 250 ml 40% HF aqueous solution to obtain the A solution;
(3) injecting the BX solution prepared into the A solution according to the order from the BX₁ solution to the BX₁₆ solution at an interval of 13 min and at an injection rate of 35 mL/s; and stirring for 3 h and layering statically in a case that a temperature is 45 °C; and
(4) post-processing: pouring out a supernatant, adding 5% HF aqueous solution, stirring and washing twice, then washing twice with anhydrous ethanol, and drying at 60 °C under a condition of blast drying, and obtaining the KSF phosphors.

A median particle size of the KSF phosphor prepared in the Embodiment 3 is 30 µm.

It could be seen from the FIG. 6 that the concentration of the tetravalent manganese ions in the radial direction from the center of the particle of the red phosphor prepared by the Embodiment 3 to the surface of the particle of the red phosphor decreases to zero non-linearly and non-uniform.

### Embodiment 4

(1) preparing BX solutions: weighing and dissolving K₂MnF₆ 2.7g, 2.65 g, 2.6g, 2.52g, 2.43g, 2.37g, 2.24g, 2.07g, 1.91g, 1.76g, 1.57g, 1.38g, 1.16g, 0.86g, 0.52g and 0g in commercially available 50g 30%-32% HSF separately to obtain 16 groups of BX solutions. That is, corresponding to a BX₁ solution (comprising K₂MnF₆ 2.7g), a BX₂ solution,..., and a BX₁₆ solution (excluding K₂MnF₆);
(2) preparing an A solution: weighing and dissolving 21g potassium hydrogen difluoride in 250 ml 40% HF aqueous solution to obtain the A solution;
(3) injecting the BX solution prepared into the A solution according to the order from the BX₁ solution to the BX₁₆ solution at an interval of 15 min and at an injection rate of 50 mL/s; and stirring for 4 h and layering statically in a case that a temperature is 45 °C; and
(4) post-processing: pouring out a supernatant, adding 5% HF aqueous solution, stirring and washing twice, then washing twice with anhydrous ethanol, and drying at 60 °C under a condition of blast drying, and obtaining the KSF phosphors.

A median particle size of the KSF phosphor prepared in the Embodiment 4 is 30 µm.

It could be seen from the FIG. 6 that the concentration of the tetravalent manganese ions in the radial direction from the center of the particle of the red phosphor prepared by the Embodiment 4 to the surface of the particle of the red phosphor decreases to zero non-linearly.

### Embodiment 5

(1) preparing BX solutions: weighing and dissolving K₂MnF₆ 2.7g, 2.69g, 2.68g, 2.68g, 2.66g, 2.63g, 2.58g, 2.51g, 2.40g, 2.25g, 2.05g, 1.81g, 1.58g, 1.32g, 0.89g and 0g in commercially available 50g 30%-32% HSF separately to obtain 16 groups of BX solutions. That is, corresponding to a BX₁ solution (comprising K₂MnF₆ 2.7g), a BX₂ solution,..., and a BX₁₆ solution (excluding K₂MnF₆);
(2) preparing an A solution: weighing and dissolving 21g potassium hydrogen difluoride in 250 ml 40% HF aqueous solution to obtain the A solution;
(3) injecting the BX solutions prepared into the A solution according to the order from the BX₁ solution to the BX₁₆ solution at an interval of 6 min and at an injection rate of 10 mL/s, and stirring for 2 h and layering statically in a case that a temperature is 45 °C; and
(4) post-processing: pouring out a supernatant, adding 5% HF aqueous solution, stirring and washing twice, then washing twice with anhydrous ethanol, and drying at 60 °C under a condition of blast drying, and obtaining the KSF phosphors.

A median particle size of the KSF phosphor prepared in the Embodiment 5 is 30 µm.

It could be seen from the FIG. 6 that the concentration of the tetravalent manganese ions in the radial direction from the center of the particle of the red phosphor prepared by the Embodiment 5 to the surface of the particle of the red phosphor decreases to zero non-linearly and non-uniform.

**Table 1**

| The addition amount of the source of the manganese in the BX solution | Embodiment 1 | Embodiment 2 | Embodiment 3 | Embodiment 4 | Embodiment 5 |
|---|---|---|---|---|---|
| BX₁/g | 2.70 | 2.70 | 2.70 | 2.70 | 2.70 |
| BX₂/g | 2.52 | 2.23 | 1.77 | 2.65 | 2.69 |
| BX₃/g | 2.34 | 1.87 | 1.27 | 2.60 | 2.68 |
| BX₄/g | 2.16 | 1.57 | 1.00 | 2.52 | 2.68 |
| BX₅/g | 1.98 | 1.34 | 0.79 | 2.43 | 2.66 |
| BX₆/g | 1.80 | 1.14 | 0.61 | 2.37 | 2.63 |
| BX₇/g | 1.62 | 0.95 | 0.48 | 2.24 | 2.58 |
| BX₈/g | 1.44 | 0.74 | 0.39 | 2.07 | 2.51 |
| BX₉/g | 1.26 | 0.59 | 0.30 | 1.91 | 2.40 |
| BX₁₀/g | 1.08 | 0.46 | 0.23 | 1.76 | 2.25 |
| BX₁₁/g | 0.90 | 0.34 | 0.17 | 1.57 | 2.05 |
| BX₁₂/g | 0.72 | 0.22 | 0.12 | 1.38 | 1.81 |
| BX₁₃/g | 0.54 | 0.15 | 0.08 | 1.16 | 1.58 |
| BX₁₄/g | 0.36 | 0.07 | 0.04 | 0.86 | 1.32 |
| BX₁₅/g | 0.18 | 0.03 | 0.02 | 0.52 | 0.89 |
| BX₁₆/g | 0.00 | 0.00 | 0.00 | 0.00 | 0.00 |

### Preparation of other phosphors

### Implementation 1

(1) in an ice-water bath, adding 150 g germanium oxide GeO₂ into 850 g 50% aqueous solution of hydrofluoric acid and mechanically stirring for 1 h, obtaining a fluogermanic acid H₂GeF₆ solution with a mass fraction of 30%;
(2) preparing BX solutions: weighing and dissolving K₂MnF₆ 2.7g, 2.52g, 2.34g, 2.16g, 1.98g, 1.80g, 1.62g, 1.44g, 1.26g, 1.08g, 0.9g, 0.72g, 0.54g, 0.36g, 0.18g and 0 g in 50g self-made mass fraction of 30% fluogermanic acid separately to obtain 16 groups of BX solutions. That is, corresponding to a BX₁ solution (comprising K₂MnF₆ 2.7g), a BX₂ solution,..., and a BX₁₆ solution (excluding K₂MnF₆ );
(3) preparing an A solution: weighing and dissolving 21g potassium hydrogen difluoride in 250 ml 40% HF aqueous solution (i.e. 40% aqueous solution of hydrofluoric acid) to obtain the A solution;
(4) injecting the BX solutions prepared into the A solution according to the order from the BX₁ solution to the BX₁₆ solution at an interval of 6 min and at an injection rate of 10 mL/s; and stirring for 2 h and layering statically in a case that a temperature is 40 °C; and
(5) post-processing: pouring out a supernatant, adding 5% HF aqueous solution (5% aqueous solution of hydrofluoric acid), stirring and washing twice, then washing twice with anhydrous ethanol, and drying at 60 °C under a condition of blast drying, and obtaining the KSF phosphors.

A median particle size of the K₂Ge₍₁₋ₓ₎F₆:xMn⁴⁺ phosphor prepared in the Example 1 is 30 µm.

### Implementation 2

(1) in an ice-water bath, adding 146 g titanium dioxide TiO₂ into 854 g 50% aqueous solution of hydrofluoric acid and mechanically stirring for 1 h, obtaining a fluogermanic acid H₂GeF₆ solution with a mass fraction of 30%;
(2) preparing BX solutions: weighing and dissolving K₂MnF₆ 2.7g, 2.52 g, 2.34g, 2.16g, 1.98g, 1.80g, 1.62g, 1.44g, 1.26g, 1.08g, 0.9g, 0.72g, 0.54g, 0.36g, 0.18g and 0 g in 50g self-made mass fraction of 30% fluogermanic acid separately to obtain 16 groups of BX solutions. That is, corresponding to a BX₁ solution (comprising K₂MnF₆ 2.7g), a BX₂ solution,..., and a BX₁₆ solution (excluding K₂MnF₆ );
(3) preparing an A solution: weighing and dissolving 21g potassium hydrogen difluoride in 250 ml 40% HF aqueous solution (i.e. 40% aqueous solution of hydrofluoric acid) to obtain the A solution;
(4) injecting the BX solution prepared into the A solution according to the order from the BX₁ solution to the BX₁₆ solution at an interval of 6 min and at an injection rate of 10 mL/s; and stirring for 2 h and layering statically in a case that a temperature is 40 °C; and
(5) post-processing: pouring out a supernatant, adding 5% HF aqueous solution (5% aqueous solution of hydrofluoric acid), stirring and washing twice, then washing twice with anhydrous ethanol, and drying at 60 °C under a condition of blast drying, and obtaining the K₂Ge₍₁₋ₓ)F₆:xMn⁴⁺ phosphors.

A median particle size of the K₂Ge₍₁₋ₓ₎F₆:xMn⁴⁺ phosphor prepared in the Example 2 is 30 µm.

### Implementation 3

(1) in an ice-water bath, adding 344 g germanium oxide GeO₂ into 656 g 50% aqueous solution of hydrofluoric acid and mechanically stirring for 1 h, obtaining a fluogermanic acid H₂GeF₆ solution with a mass fraction of 30%;
(2) preparing BX solutions: weighing and dissolving Na₂MnF₆ 2.35g, 2.19g, 2.04g, 1.88g, 1.72g, 1.57g, 1.41g, 1.25g, 1.10g, 0.94g, 0.78g, 0.63g, 0.47g, 0.31g, 0.16g and 0 g in 50g self-made mass fraction of 30% fluogermanic acid separately to obtain 16 groups of BX solutions. That is, corresponding to a BX₁ solution (comprising Na₂MnF₆ 2.35g), a BX₂ solution,..., and a BX₁₆ solution (excluding Na₂MnF₆ );
(3) preparing an A solution: weighing and dissolving 16.6g sodium fluoride in 250 ml 40% HF aqueous solution (i.e. 40% aqueous solution of hydrofluoric acid) to obtain the A solution;
(4) injecting the BX solution prepared into the A solution according to the order from the BX₁ solution to the BX₁₆ solution at an interval of 6 min and at an injection rate of 10 mL/s; and stirring for 2 h and layering statically in a case that a temperature is 40 °C;
(5) post-processing: pouring out a supernatant, adding 5% HF aqueous solution (5% aqueous solution of hydrofluoric acid), stirring and washing twice, then washing twice with anhydrous ethanol, and drying at 60 °C under a condition of blast drying, and obtaining the K₂Ge₍₁₋ₓ)F₆:xMn⁴⁺ phosphors.

A median particle size of the K₂Ge₍₁₋ₓ₎F₆: xMn⁴⁺ phosphor prepared in the Example 3 is 30 µm.

### Energy spectrum analysis test

The KSF phosphors prepared by the Embodiments 1-5 are cut by double-beam ion. The energy spectrum analysis is carried out on 16 points evenly taken from the center A to the surface B of the fresh surface. As shown in FIG. 5, FIG. 5 is a sampling points schematic diagram of energy spectrum analysis of the K₂SiF₆:Mn⁴⁺ phosphors prepared in the Embodiment 1, and the percentage of Mn atoms at the point is shown in Table 2 and FIG. 6. The way of taking points of the KSF phosphors prepared by Embodiments 2-5 could be referred to the way of taking points of the Embodiment 1 in FIG. 5, and the percentage of Mn atoms at the points is shown in Table 2 and FIG. 6. Therefore, there is no further elaboration here.

**Table 2**

| Atom fraction % | Embodiment 1 | Embodiment 2 | Embodiment 3 | Embodiment 4 | Embodiment 5 |
|---|---|---|---|---|---|
| | 0.81 | 0.80 | 0.80 | 0.79 | 0.81 |
| | 0.75 | 0.66 | 0.53 | 0.78 | 0.80 |
| | 0.69 | 0.55 | 0.38 | 0.77 | 0.80 |
| | 0.64 | 0.47 | 0.30 | 0.75 | 0.79 |
| | 0.59 | 0.40 | 0.23 | 0.72 | 0.79 |
| | 0.53 | 0.34 | 0.18 | 0.70 | 0.78 |
| | 0.48 | 0.28 | 0.14 | 0.66 | 0.76 |
| At% | 0.43 | 0.22 | 0.12 | 0.61 | 0.74 |
| | 0.37 | 0.17 | 0.09 | 0.57 | 0.71 |
| | 0.32 | 0.14 | 0.07 | 0.52 | 0.67 |
| | 0.27 | 0.10 | 0.05 | 0.47 | 0.61 |
| | 0.21 | 0.06 | 0.04 | 0.41 | 0.54 |
| | 0.16 | 0.04 | 0.02 | 0.34 | 0.47 |
| | 0.11 | 0.02 | 0.01 | 0.26 | 0.39 |
| | 0.05 | 0.01 | 0.01 | 0.15 | 0.26 |
| | 0.00 | 0.00 | 0.00 | 0.00 | 0.00 |

Combined with the Table 2 and the FIG. 6, it could be seen that the concentration of tetravalent manganese ions in the radial direction from the center to the surface of the particle of the red phosphor prepared by Embodiments 1-5 is gradually reduced. It could be seen from the decreasing trend of the concentration of Mn⁴⁺ in the FIG. 6 that the concentration of Mn⁴⁺ in the Embodiment 1 decreases linearly and uniformly along the radial direction from the center of the particle to its surface. Especially in the form of arithmetic sequence for uniform decline, the decreasing trend is a straight line, and the distance between two adjacent points on the straight line are equal. The concentrations of Mn⁴⁺ in the Embodiments 2-5 are non-uniformly decreasing along the radial direction from the center of the particle to its surface, and the decreasing trends are curvilinear declines, and the concentrations of Mn⁴⁺ on the surfaces of the particles of the Embodiments 1-5 are both 0.

### Embodiment 6

Similar to the Embodiment 1, the difference is that in the process of the preparing the BX solutions, only the BX₁ solution to the BX₁₀ solution are prepared. That is, in the KSF phosphors prepared by the Embodiment 6, the ratio of the percentage of the manganese atoms on the surface (denoted as x₂) to the percentage of the manganese atom in the center (denoted as x₁) is given by x₂/x₁=0.395.

### Embodiment 7

Similar to the Embodiment 1, the difference is that in the process of the preparing the BX solutions, only the BX₁ solution to the BX₁₂ solution are prepared. The KSF phosphors prepared by the Embodiment 7 does not contain the manganese-free shell layer, and the ratio of the percentage of the manganese atom on the surface (denoted as x₂) to the percentage of the manganese atom in the center (denoted as x₁) is given by x₂/x₁= 0.26.

### Embodiment 8

Similar to the Embodiment 1, the difference is that in the process of the preparing the BX solutions, only the BX₁ solution to the BX₁₄ solution are prepared. The KSF phosphor prepared by the Embodiment 8 does not contain the manganese-free shell layer, and the ratio of the percentage of the manganese atoms on the surface (denoted as x₂) to the percentage of the manganese atoms in the center (denoted as x₁) is given by x₂/x₁= 0.14.

### Comparison 1

Similar to the Embodiment 1, the difference is that all K₂MnF₆ is directly put into 10%-15% HSF in the process of the preparing the BX solutions. That is, it is not added in a descending gradient way. Specifically, 21.6 g of K₂MnF₆ is dissolved in commercially available 800 g of 10%-15% HSF, which is divided into 16 groups on average, and 16 groups of BX₁-BX₁₆ solutions with the same content of K₂MnF₆ are obtained. Then, the BX₁-BX₁₆ solutions are injected into the A solution at an injection rate of 10 mL/s with an interval of 6 min in turn, and the rest are the same as those in Embodiment 1.

Table 3 shows the test method and equipment of 1000 hours aging test in the present application. Table 4 shows the aging test data of the phosphor prepared by the Embodiments 1-8, the Implementations 1-2 and Comparisons 1-2. (description: KSF-0 is a sample of the Comparison 1, KSF-1 is a sample of the Embodiment 1, KSF-2 is a sample of the Embodiment 2, KSF-3 is a sample of the Embodiment 3, KSF-4 is a sample of the Embodiment 4, KSF-5 is a sample of the Embodiment 5, KSF-6 is a sample of the Embodiment 6, KSF-7 is a sample of the Embodiment 7, KSF-8 is a sample of the Embodiment 8, KSF-9 is a sample of the Implementation 1 , KSF-10 is a sample of the Implementation 2, KSF-11 is a sample of the Implementation 3).

**Table 3**

| Model numbe r | Manufacture scheme | Bracket type | Chip | Current | Ageing conditioning | Test machine |
|---|---|---|---|---|---|---|
| KSF-0 | | | | | Temperature: 85°C | |
| KSF-1 | | | | | | |
| KSF-2 | | | | | | |
| KSF-3 | | | | | | |
| KSF-4 | | | | | | |
| KSF-5 | | | | | | |
| KSF-6 | Positive white color temperature full spectrum | SMD-2835 | 22*25mil Double wafer parallel connectio n | 65 mA | | EVERFINE HAAS2000 |
| KSF-7 | | | | | Humidity: 85RH% | |
| KSF-8 | | | | | | |
| KSF-9 | | | | | | |
| KSF-10 | | | | | | |
| KSF-11 | | | | | | |

| Parameter | Testing time (h) | | | | |
|---|---|---|---|---|---|
| | 0 | 250 | 500 | 750 | 1000 |
| KSF-0 Luminous flux(lm) | 128.30 | 127.58 | 126.87 | 125.14 | 123.56 |
| KSF-0 Brightness ratio(%) | 100% | 99.4% | 98.9% | 97.5% | 96.2% |
| KSF-1 Luminous flux(lm) | 128.21 | 127.95 | 127.44 | 125.18 | 127.05 |
| KSF-1 Brightness ratio(%) | 100% | 99.8% | 99.4% | 99.2% | 99.1% |
| KSF-2 Luminous flux(lm) | 125.31 | 125.06 | 124.68 | 124.18 | 124.05 |
| KSF-2 Brightness ratio(%) | 100% | 99.8% | 99.5% | 99.1% | 99.0% |
| KSF-3 Luminous flux(lm) | 123.24 | 123.12 | 122.50 | 122.37 | 122.13 |
| KSF-3 Brightness ratio(%) | 100% | 99.9% | 99.4% | 99.3% | 99.1% |
| KSF-4 Luminous flux(lm) | 128.36 | 127.84 | 127.33 | 127.20 | 126.81 |
| KSF-4 Brightness ratio(%) | 100% | 99.6% | 99.2% | 99.1% | 98.8% |
| KSF-5 Luminous flux(lm) | 128.27 | 127.62 | 127.11 | 126.98 | 126.60 |
| KSF-5 Brightness ratio(%) | 100% | 99.5% | 99.1% | 99.0% | 98.7% |

**Table 4**

| | | | | | |
|---|---|---|---|---|---|
| KSF-6 Luminous flux(lm) | 128.32 | 127.16 | 126.26 | 125.24 | 124.21 |
| KSF-6 Brightness ratio(%) | 100% | 99.1% | 98.4% | 97.6% | 96.8% |
| KSF-7 Luminous flux(lm) | 128.17 | 127.27 | 126.63 | 125.47 | 124.58 |
| KSF-7 Brightness ratio(%) | 100% | 99.3% | 98.8% | 97.9% | 97.2% |
| KSF-8 Luminous flux(lm) | 128.31 | 127.54 | 126.89 | 125.74 | 125.35 |
| KSF-8 Brightness ratio(%) | 100% | 99.4% | 98.9% | 98.0% | 97.7% |
| KSF-9 Luminous flux(lm) | 128.90 | 127.72 | 126.32 | 122.97 | 120.9 |
| KSF-9 Brightness ratio(%) | 100% | 99.1% | 98.0% | 95.4% | 93.8% |
| KSF-10 Luminous flux(lm) | 128.5 | 127.47 | 126.31 | 122.97 | 121.04 |
| KSF-10 Brightness ratio(%) | 100% | 99.2% | 98.3% | 95.7% | 94.2% |
| KSF-11 Luminous flux(lm) | 124.8 | 123.30 | 121.80 | 118.43 | 115.93 |
| KSF-11 Brightness ratio(%) | 100% | 98.8% | 97.6% | 94.9% | 92.9% |

Combined with the data in the Table 4, it could be seen that the concentration of the tetravalent manganese ions in the particle of the phosphor gradually decreases along the radial direction, which is beneficial to the improvement of anti-aging performance. For the Comparison 1 without gradient setting of the concentration of the tetravalent manganese ions, the luminous flux of the Comparison 1 at 0 h is 128.30 lm, and the luminous flux of the Comparison 1 after 1000 h is only 123.56 lm, which is reduced by 4.74 lm, and the brightness ratio of the phosphor prepared by the Comparison 1 after 1000 h is significantly reduced from 100% to 96.2%. However, the luminous flux of the Embodiment 1 with the concentration of the tetravalent manganese ions decreasing gradient along the radial direction of the present application is only 1.16 lm, which is lower than that of 0 h after 1000 hours of use, and the brightness ratio of the phosphor prepared by the Embodiment 1 could be as high as 99.1% after 1000 hours of use. It could be seen that the service life of the phosphor with a decreasing concentration gradient of the tetravalent manganese ions is longer. The comparisons between KSF-1 and KSF-2 to KSF-5 show that the concentration of the tetravalent manganese ions decreases linearly and uniformly in the radial direction from the center of the phosphor particle to the surface of the phosphor particle, which is more conducive to the improvement of its anti-aging performance, and the ability to delay the erosion of water vapor.

Comparing KSF-9 to KSF-11 with KSF-1, it could be seen that when the A is a K element and the M is an Si element, the performance of the phosphor is the best, and for the selection of the source of the A and the source of the M, potassium hydrogen difluoride and fluorosilicic acid are preferred.

Understandably, the above implementation methods are only embodiments implementation method used to illustrate the principle of the present application, and the present application is not limited to this. For ordinary technical personnel in this field, without deviating from the spirit and essence of the present application, various variants and improvements can be made, which are also regarded as the protection scope of the present application.

## Claims

1. A red phosphor, wherein, the red phosphor is selected from any one of substances shown in a formula I;
A₂M₍₁₋ₓ₎F₆:xMn⁴⁺ the formula I;
in the formula I, the A is selected from at least one of alkali metal elements;
the M is selected from at least one of IVA group elements or a Ti element;
a value range of the x is 0<x≤0.05;
the red phosphor is granular; and
a concentration of tetravalent manganese ions of a particle of the red phosphor decreases gradually in a radial direction from a center of the particle of the red phosphor to a surface of the particle of the red phosphor.

2. The red phosphor of claim 1, wherein, in the formula I, the A is selected from at least one of a Na element and a K element; and/or,
the M is selected from at least one of an Si element, a Ge element or the Ti element.

3. The red phosphor of claim 1, wherein, the concentration of the tetravalent manganese ions of the particle of the red phosphor decreases linearly and uniformly in the radial direction from the center of the particle of the red phosphor to the surface of the particle of the red phosphor.

4. The red phosphor of claim 1, wherein, the concentration of the tetravalent manganese ions on the surface of the particle of the red phosphor is zero.

5. The red phosphor of claim 1, wherein, a percentage of manganese atoms in the center of the particle of the red phosphor is denoted as x₁%, and the percentage of the manganese atoms on the surface of the particle of the red phosphor is denoted as x₂%, satisfying: 0≤x₂/x₁<1.

6. The red phosphor of claim 5, wherein, the x₂/x₁ further satisfies 0≤x₂/x₁≤0.33.

7. The red phosphor of claim 5, wherein, the percentage of the manganese atoms in the center of the particle of the red phosphor is x₁%, satisfying: 0.1≤x₁<5.

8. The red phosphor of claim 7, wherein, the percentage of the manganese atoms in the center of the particle of the red phosphor is x₁%, further satisfying: 0.5≤x₁<1.

9. The red phosphor of claim 5, wherein, the percentage of the manganese atoms on the surface of the particle of the red phosphor is x₂%, satisfying: 0≤x₂<0.1.

10. A preparation method for the red phosphor of any one of claims 1 to 9, **characterized in that** the preparation method comprises following steps:
(1) obtaining a mixed solution of a source of the A and an aqueous solution of hydrofluoric acid, denoted as an A solution;
(2) obtaining a mixed solution of a source of Mn and a source of the M, denoted as BX solutions; wherein
the BX solutions comprises BX₁ solution, BX₂ solution,..., BXₙ solution, the n satisfies: n≥5, and a content of the source of Mn from the BX₁ solution to the BXₙ solution decreases gradually;
optionally, the content of the source of Mn in the BXₙ solution is 0;
(3) injecting the BX solutions from (2) into the A solution from (1) in an order from the BX₁ solution to the BXₙ solution for reactions, and obtaining the red phosphor.

11. The preparation method of claim 10, wherein, in step (2), the content of the source of Mn from the BX₁ solution to the BXₙ solution decreases linearly and uniformly;
optionally, the content of the source of Mn from the BX₁ solution to the BXₙ solution decreases uniformly in a form of an arithmetic sequence.

12. The preparation method of claim 10, wherein, in step (3), an injection rate of each BX solution is 10-50 mL/s, and an injection interval is 5-15 min; and
conditions of each reaction are as follows: a reaction temperature is 40-50°C, and reaction time is 2-4 h.

13. The preparation method of claim 10, wherein: in step (1), a mass ratio of the source of the A to the hydrofluoric acid is 20-25: 95-105; and
in step (2), a molar percentage of the source of Mn to the source of the M is denoted as M₁ in the BX₁ solution, and a molar percentage of the source of Mn to the source of the M is denoted as M₂ in the BXₙ solution, satisfying 0≤M₂/M₁<1.

14. Use of the red phosphor of any one of claims 1 to 9 or the red phosphor prepared by the preparation method of any one of claims 10 to 13 in a field of an LCD backlight source or a field of LED lighting.

15. An LCD backlight source, **characterized in that**: the LCD backlight source comprises an excitation chip and a phosphor coated on the excitation chip;
the phosphor is the red phosphor of any one of claims 1 to 9; or,
the phosphor is the red phosphor prepared by the preparation method of any one of claims 10 to 13.

16. A lighting device, **characterized in that**: the lighting device comprises a light emitting device;
the light emitting device comprises an excitation chip and a phosphor coated on the excitation chip;
the phosphor is the red phosphor of any one of claims 1 to 9; or,
the phosphor is the red phosphor prepared by the preparation method of any one of claims 10 to 13.
